# FASCICULE DE BREVET EUROPEEN

(11) **EP 3 594 699 B1**
(45) Date de publication et mention de la délivrance du brevet: **01.11.2023**
(21) Numéro de dépôt: 19177898.4
(22) Date de dépôt: 03.06.2019
(51) Int. Cl.: G01R 19/00, G01R 19/10, H02H 1/06, H02H 3/33, H02H 3/347, H02H 9/04

(54) **DISPOSITIF DE PROTECTION DIFFÉRENTIELLE**
DIFFERENTIALSCHUTZVORRICHTUNG
DIFFERENTIAL PROTECTION DEVICE

(30) Priorité: 12.07.2018 FR 1856437
(43) Date de publication de la demande: 15.01.2020
(73) Titulaire: HAGER-ELECTRO SAS, 67210 Obernai (FR)
(72) Inventeur: DOLISY, Bastien, 67210 OBERNAI (FR); JOYEUX, Patrice, 67140 HEILIGENSTEIN (FR)
(74) Mandataire: Cabinet Nuss

(56) Documents cités:
- EP-A1- 2 445 074
- WO-A1-2017/093670
- WO-A2-2017/072442
- DE-A1- 19 937 061
- DE-A1- 19 940 344
- DE-A1-102011 011 984
- JP-A- H01 243 816
- US-A- 3 512 045
- US-A1- 2009 063 064

## Description

La présente invention concerne le domaine des dispositifs de protection différentielle, préférentiellement de type B et/ou B+, ainsi que des appareils électriques de protection comprenant un tel dispositif de protection différentielle.

De manière connue, un dispositif de protection différentielle de type B et/ou B+, permet notamment la détection de courants de défaut à composantes continue et alternative. Plus particulièrement, un dispositif de protection différentielle de type B, permet de détecter des courants de défaut pour des fréquences allant de 0 jusqu'à 1 kiloHertz, tandis qu'un dispositif de protection différentielle de type B+ permet de détecter des courants de défaut allant de 0 jusqu'à 20 kiloHertz. Pour ce faire, un dispositif de protection différentielle du type B et/ou B+ comprend habituellement un module de mesure d'un courant de défaut configuré pour fournir un signal de défaut proportionnel au courant de défaut comprenant au moins un tore traversé par au moins deux conducteurs, d'une installation électrique, formant un enroulement primaire et comprenant un enroulement secondaire apte à fournir le signal de défaut représentant le courant de défaut. Le dispositif comprend, en outre, un module de détection et de commande configuré pour traiter le signal de défaut et pour commander un actionneur que comprend le dispositif si le signal de défaut franchit un seuil de déclenchement prédéterminé.

Par ailleurs, pour la protection des installations dans des locaux industriels, il est approprié de choisir un dispositif de protection différentielle de type B et/ou B+ sélectif, dont le seuil de déclenchement est, par exemple, de 300 milliampères, afin de protéger les locaux contre les incendies. Par ailleurs, les normes actuellement en vigueur, et notamment les normes IEC 62423 et IEC 61008, imposent que les temps de déclenchement d'un dispositif de protection différentielle de type B et/ou B+ sélectif, ayant un seuil de déclenchement de Idn, soient compris entre 150 millisecondes et 500 millisecondes pour une fréquence égale à 50 Hertz à Idn et pour une fréquence de 1 kilohertz à 14 Idn, le temps de déclenchement doit être compris entre 130 millisecondes et 500 millisecondes. Par exemple, pour la sensibilité de 300 milliampères, les normes précitées, imposent un test à 5 Ampères et à 50 Hertz, pour lequel les temps de déclenchement doivent être compris entre 40 millisecondes et 150 millisecondes et un autre test à 4,2 Ampères et à 1000 Hertz, pour lequel les temps de déclenchement doivent être compris entre 130 millisecondes et 500 millisecondes.

À l'heure actuelle, des dispositifs de protection de type B et/ou B+ sélectif, fonctionnels et conformes aux normes précitées, présentent l'inconvénient de dépendre au moins partiellement de l'alimentation du réseau pour garantir leur fonctionnement en haute fréquence, c'est-à-dire pour des fréquences comprises entre quelques dizaines de Hertz à quelques dizaines de kiloHertz.

Le document DE102011011984A1 divulgue un dispositif de protection différentielle selon le préambule de la revendication 1 mais qui n'est pas conforme aux normes IEC 62423 et IEC 61008.

La présente invention a pour but de pallier ces inconvénients en proposant une solution conforme aux normes précitées et ne nécessitant pas d'être alimentée par le réseau.

A cet effet, la présente invention concerne un dispositif de protection différentielle, préférentiellement de type B et/ou B+, pour la détection de courants de fuite ou de défaut dans une installation électrique, selon la revendication 1.

L'invention sera mieux comprise, grâce à la description ci-après, qui se rapporte à plusieurs modes de réalisation préférés, donnés à titre d'exemples non limitatifs, et expliqués avec référence aux dessins schématiques annexés, dans lesquels :
la figure 1 est une représentation schématique du dispositif de protection différentielle selon l'invention dans un premier mode de réalisation,
la figure 2 est un schéma électrique d'une partie du dispositif de protection différentielle selon l'invention dans le premier mode de réalisation,
la figure 3 est une représentation schématique du dispositif de protection différentielle selon l'invention dans un deuxième mode de réalisation, et
la figure 4 est un schéma électrique d'une partie du dispositif de protection différentielle selon l'invention dans le deuxième mode de réalisation.

Un dispositif 1 de protection différentielle, préférentiellement de type B et/ou B+, pour la détection de courants de fuite ou de défaut dans une installation électrique, laquelle est apte et destinée à être alimentée, soit par au moins deux conducteurs 2, 2', 2", N d'un réseau, soit par au moins un conducteur de phase 2, 2', 2" du réseau et par un conducteur de neutre N du réseau, comprend :
- un module de mesure 3 d'un courant de défaut configuré pour fournir un signal de défaut proportionnel au courant de défaut en cas de défaut dans l'installation électrique comprenant au moins un tore 4 traversé par au moins deux des conducteurs 2, 2', 2", N formant un enroulement primaire et comprenant au moins un enroulement secondaire 5, 5" apte à fournir le signal de défaut,
- un module de détection et de commande 6 configuré pour traiter une composante alternative du signal de défaut et dont les fréquences sont comprises entre quelques dizaines de Hertz à quelques dizaines de kiloHertz, et pour commander un actionneur 7 que comprend le dispositif 1 si le signal de défaut franchit un seuil de déclenchement prédéterminé.

Conformément à l'invention, le dispositif 1 est caractérisé en ce que :
le module de détection et de commande 6 est autonome en termes d'alimentation électrique et est indépendant de la tension du réseau et est relié au moins audit au moins un enroulement secondaire 5, 5" pour être alimenté par le courant de défaut,
le module de détection et de commande 6 comprend une unité de traitement 8 dudit signal de défaut, configurée pour fournir en sortie de l'unité de traitement 8, un signal traité dont la tension à 50 Hertz Vtore(50Hz) est supérieure à la tension à 1 kiloHertz Vtore(100OHz) pour une même valeur de l'intensité du courant de défaut.

Avantageusement, le module de mesure 3 et le module de détection et de commande 6 forment un module AC/A/HI/G/F. En outre, pour fonctionner et être conforme aux normes IEC 62423 et IEC 61008, le module de détection et de commande 6 ne nécessite que l'énergie électrique fournie par le courant de défaut. Aucune alimentation électrique, ni aucun raccordement électrique au réseau n'est nécessaire pour garantir le fonctionnement conforme de ce module de détection et de commande 6. Ceci est rendu possible grâce à l'unité de traitement 8, qui, pour un courant de défaut identique, permet de traiter aussi bien un signal de défaut à la fréquence de 50 Hertz qu'un signal de défaut à la fréquence de 1000 Hertz, c'est-à-dire en permettant un déclenchement de l'actionneur 7 selon un temps de déclenchement conforme aux normes IEC 62423 et IEC 61008. Avantageusement, grâce à cette unité de traitement 8, il est possible, en fournissant un signal traité tel que la tension à 50 Hertz Vtore(50Hz) soit supérieure à la tension à 1 kiloHertz Vtore(1000Hz), pour le même niveau de courant de défaut et pour des courants forts, dont l'intensité est par exemple comprise entre 4 Ampères et 5 Ampères, d'augmenter le temps de déclenchement de l'actionneur 7 pour une fréquence de 1000 Hertz, sans augmenter le temps de déclenchement de l'actionneur 7 pour une fréquence de 50 Hertz.

Il en résulte que dans cette configuration le dispositif 1 peut présenter des temps de déclenchement compris entre 130 millisecondes et 150 millisecondes, par exemple pour un courant de défaut valant 4,5 Ampères, aussi bien à 50 Hertz qu'à 1000 Hertz.

Ce dispositif 1 peut consister en un dispositif de protection différentielle du type B ou B+ sélectif.

De préférence, ce dispositif 1 peut présenter une sensibilité de 100 milliampères ou de 300 milliampères ou de 500 milliampères ou de 1 Ampères ou de 2 Ampères.

Ce réseau d'alimentation 2, 2', 2", N peut être : un réseau triphasé avec neutre 2, 2', 2" et N ; un réseau triphasé sans neutre 2, 2' et 2" ; un réseau biphasé 2, 2' ou encore un réseau monophasé 2, N (2, 2', 2" : conducteurs de phase / N : neutre).

Ce module de détection et de commande 6 peut être du type AC/A, Hi/G ou F.

De préférence, ce module de détection et de commande 6 peut être configuré pour traiter une composante alternative du signal de défaut dont les fréquences sont comprises entre 30 Hertz et 250 kiloHertz.

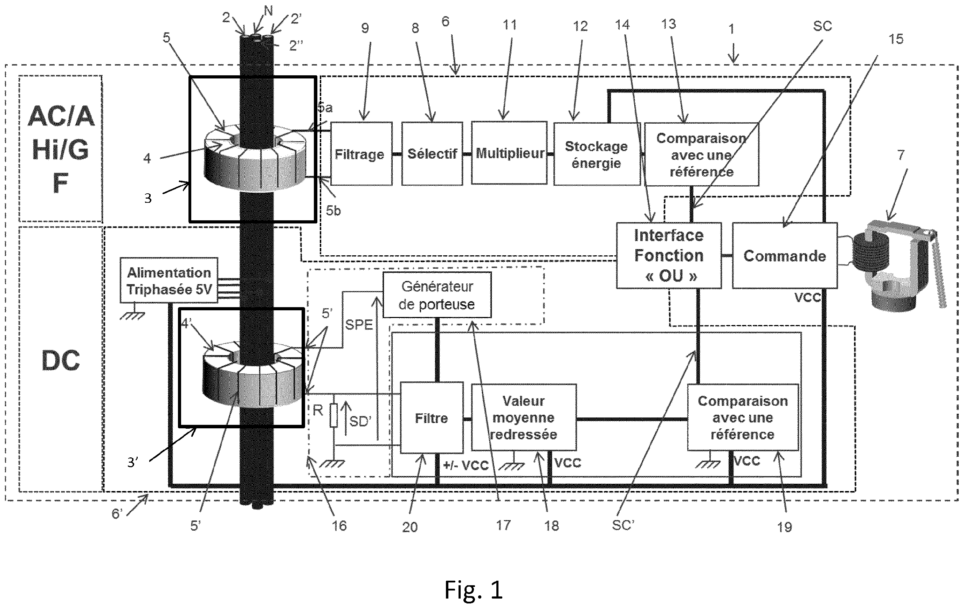

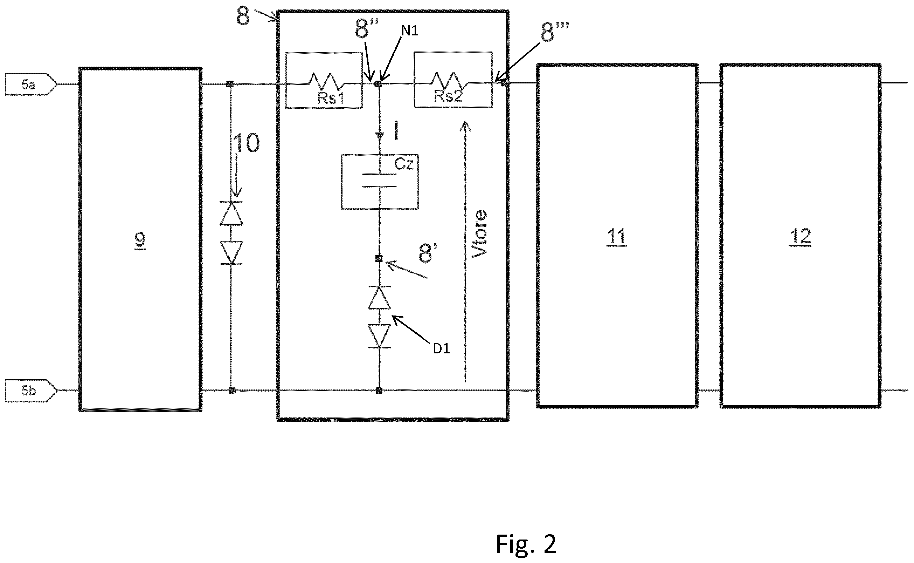

Selon un premier mode de réalisation illustré aux figures 1 et 2, le dispositif 1 comprend un unique enroulement secondaire 5 et le module de détection et de commande 6 est relié aux bornes 5a, 5b de l'unique enroulement secondaire 5.

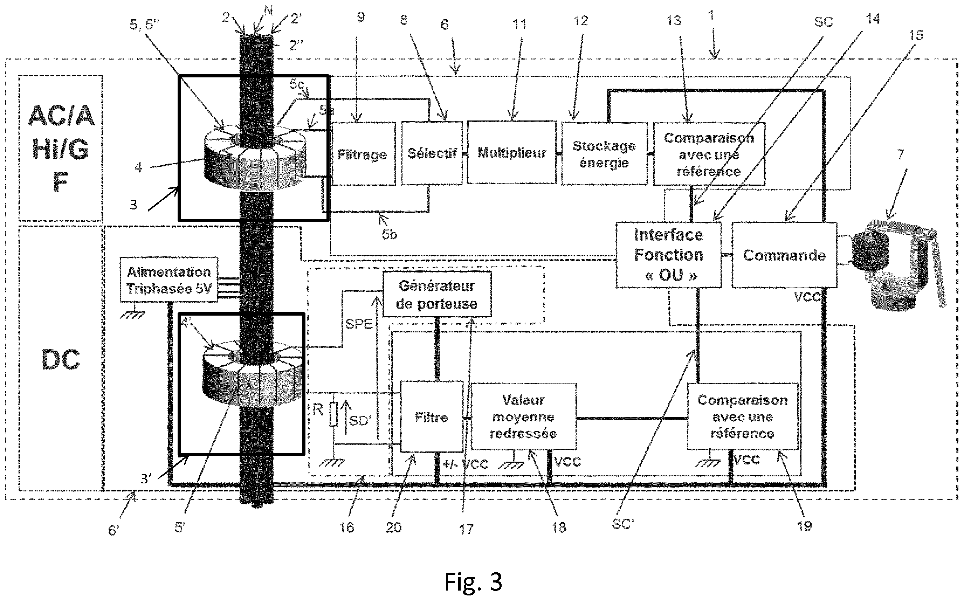

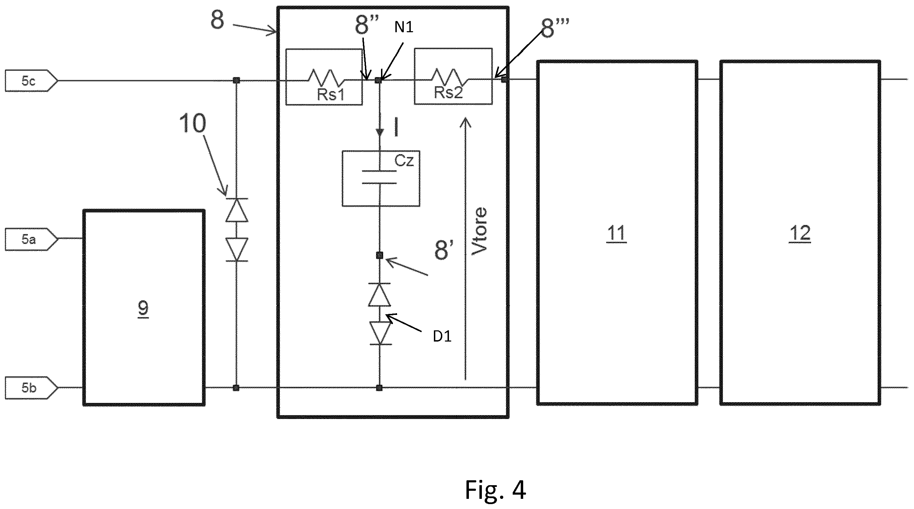

Selon un deuxième mode de réalisation alternatif, illustré aux figures 3 et 4, le dispositif 1 comprend un premier enroulement secondaire 5 et un deuxième enroulement secondaire 5" et le module de détection et de commande 6 est relié aux bornes 5a, 5b du premier enroulement secondaire et à au moins une borne 5c du deuxième enroulement secondaire 5".

Préférentiellement, le deuxième enroulement secondaire 5" peut comprendre un nombre de spires qui est supérieur ou égal au nombre de spires du premier enroulement secondaire 5.

Par exemple, le nombre de spires du deuxième enroulement secondaire 5" peut valoir le double du nombre de spires du premier enroulement secondaire 5.

Conformément à l'invention, et comme l'illustrent les figures 2 et 4, l'unité de traitement 8 comprend un circuit électronique comprenant une première branche 8' comprenant un condensateur Cz, dont au moins l'impédance à 50 Hertz Zcz(50Hz) est supérieure à l'impédance à 1000 Hertz Zcz(1000Hz), en série avec au moins un composant dont l'impédance varie en fonction de la tension, préférentiellement une diode D1.

Ce composant dont l'impédance varie en fonction de la tension, préférentiellement une diode D1, est prévu pour augmenter le temps de déclenchement à 1000 Hertz, en influant sur la valeur de la tension Vtore pour des courants forts. Toutefois, l'ajout de cette diode D1 seule augmente également les temps de déclenchement à 50 Hertz pour des courants forts. C'est pourquoi, il est nécessaire de combiner la diode D1 en série avec un condensateur Cz, préférentiellement situé en amont de celle-ci, dont l'impédance Zcz varie en fonction de la fréquence, de sorte que l'impédance à 50 Hertz Zcz(50Hz) soit supérieure à l'impédance à 1000 Hertz Zcz(1000Hz). Ainsi, comme dans cette première branche 8', la tension Vtore suit la relation suivante : Vtore=VD1+Zcz×I, avec I l'intensité du courant traversant la première branche 8', et VD1, la tension aux bornes de la diode D1, I et VD1 étant des constantes, il vient que Vtore(50Hz) >Vtore(1000Hz). Avantageusement, on obtient un seuil de tension qui varie en fonction de la fréquence. Il en résulte que dans cette configuration le dispositif 1 fournit une solution conforme aux normes précitées, ne nécessitant pas d'être alimenté par le réseau et qui, de surcroît, est peu coûteuse, puisque seulement deux composants électroniques sont nécessaires à sa mise en oeuvre.

Par exemple, la diode D1 est une diode Zener, et celle-ci laisse passer le courant lorsque la tension à ses bornes atteint la tension Zener VZener, puis maintient cette valeur de tension VZener à ses bornes. Ainsi, lorsque la diode D1 est une diode Zener VD1=VZener et la tension Vtore, suit la relation suivante : Vtore=VZener+Zcz×I, avec I l'intensité du courant traversant la première branche 8', et VD1, la tension de la diode D1, I et VZener étant des constantes, il vient que Vtore(50Hz) >Vtore(1000Hz). De préférence, la valeur de la tension Zener VZener vaut 2,4 Volts.

Selon une autre possibilité, la diode D1 est une diode Transil.

De préférence, ce circuit électronique de l'unité de traitement 8 peut comprendre, en outre, une deuxième branche 8" comprenant une première résistance Rs 1 reliée à un premier noeud N1 de la première branche 8' en amont de ce dernier (figures 2 et 4).

Cette première résistance Rs1 est prévue pour influer et régler l'écart entre l'amplitude à 50 Hertz et l'amplitude à 1 kiloHertz pour un courant donné. De préférence, ce circuit électronique de l'unité de traitement 8 peut comprendre, en outre, une troisième branche 8'" comprenant une deuxième résistance Rs2 reliée au premier noeud N1 en aval de ce dernier (figures 2 et 4).

Cette deuxième résistance Rs2 est prévue pour influer sur et régler le niveau de tenue de l'onde 8/20 microsecondes qui est de 5 kiloAmpères pour les produits sélectifs. Ce circuit électronique de l'unité de traitement 8 peut être prévu pour être alimenté par le signal de défaut provenant du module de mesure 3. Dans ce cas, la première branche 8' peut être reliée aux bornes 5a, 5b de l'unique enroulement secondaire 5 ou aux bornes 5c du deuxième enroulement secondaire 5". Ce circuit électronique de l'unité de traitement 8 peut être prévu pour être alimenté par le signal de défaut ayant subi un prétraitement, par exemple par l'intermédiaire d'un circuit de filtrage 9 décrit ci-après.

Conformément à une première spécificité non-limitative de l'invention et des premier et deuxième modes de réalisation et de leurs particularités, le module de détection et de commande 6 comprend, en outre, un circuit de filtrage 9 pour filtrer une bande passante de fréquences du signal de défaut, relié aux bornes 5a, 5b, 5c dudit au moins un enroulement secondaire 5, 5" entre le module de mesure 3 et l'unité de traitement 8.

Avantageusement, le circuit de filtrage 9 permet de maîtriser la bande passante du module de détection et de commande 6.

Par exemple, cette bande passante peut être comprise entre 25 Hertz et 250 kiloHertz.

Dans le premier mode de réalisation et comme l'illustrent les figures 1 et 2, le circuit de filtrage 9 est relié aux bornes 5a, 5b de l'unique enroulement secondaire 5.

Dans le deuxième mode de réalisation et comme l'illustrent les figures 3 et 4, le circuit de filtrage 9 est relié aux bornes 5a, 5b dudit premier enroulement secondaire 5.

Conformément à une deuxième spécificité non-limitative de l'invention et des premier et deuxième modes de réalisation et de leurs particularités ou de la première spécificité, le module de détection et de commande 6 comprend, en outre, un élément de protection 10 contre un courant de défaut fort, par exemple dont le seuil peut être compris entre 1 Volt et 4 Volts suivant le nombre de spires du tore 4, en amont de l'unité de traitement 8.

Avantageusement, cet élément de protection est prévu pour protéger notamment l'unité de traitement 8.

Cet élément de protection 10 peut consister en une diode Transil.

De préférence selon la première spécificité des premier et deuxième modes de réalisation, l'élément de protection 10 est relié électriquement entre le circuit de filtrage 9 et l'unité de traitement 8.

Plus particulièrement, dans le premier mode de réalisation, et comme l'illustre la figure 2, l'élément de protection 10 est relié en parallèle, en aval du circuit de filtrage 9 et en amont de l'unité de traitement 8.

Plus particulièrement, dans le deuxième mode de réalisation, et comme l'illustre la figure 4, l'élément de protection 10 est relié en parallèle, en amont de l'unité de traitement 8, d'une part, à une borne 5b qui est reliée au circuit de filtrage 9 et d'autre part, à une borne 5c du deuxième enroulement secondaire 5".

Conformément à une troisième spécificité non-limitative de l'invention et des premier et deuxième modes de réalisation et de leurs particularités ou des première et deuxième spécificités, le module de détection et de commande 6 comprend, en outre, un circuit multiplieur de tension 11 relié électriquement en aval de l'unité de traitement 8.

Avantageusement, le circuit multiplieur de tension 11 est prévu pour effectuer une multiplication de la tension du signal entrant d'un facteur n. Ce facteur n peut, par exemple, être égal à 2 ou 4 ou 8.

Avantageusement, cette configuration permet d'emmagasiner l'énergie du courant de défaut, de diminuer le volume du tore 4, lequel peut être plus compact, et de régler les temps de déclenchement.

Préférentiellement, le module de détection et de commande 6 comprend, en outre, des moyens de stockage de l'énergie 12 pour commander ledit actionneur 7, relié électriquement en aval du circuit multiplieur de tension 11.

Ces moyens de stockage de l'énergie 12 sont prévus pour stocker l'énergie électrique nécessaire à l'actionnement de l'actionneur 7.

Préférentiellement, les moyens de stockage de l'énergie 12 peuvent par exemple consister en un condensateur.

Le module de détection et de commande 6 peut comprendre un circuit comparateur 13 disposé en aval des moyens de stockage de l'énergie 12 et configuré pour comparer ledit signal provenant des moyens de stockage de l'énergie 12 à une valeur seuil et délivrant conditionnellement ou sélectivement un signal de commande SC de l'actionneur 7, en fonction du résultat de ladite comparaison (figures 1 et 3).

Le module de détection et de commande 6 peut comprendre un circuit de commande 15 en aval du circuit comparateur 13 et en amont de l'actionneur 7 configuré pour commander l'actionneur 7 à partir du signal de commande SC. Ce circuit de commande 15 peut comprendre un organe de commande de type semi-conducteur, comme un thyristor ou un transistor.

Préférentiellement, le dispositif 1 peut comprendre, en outre, un module de détection et de commande 6' qui est fonctionnellement actif ou opérationnel pour des fréquences du signal de défaut de 0 Hertz à quelques dizaines de Hertz, ce module de détection et de commande 6' étant alimenté par le réseau. Ce module de détection et de commande 6' comprend un module de mesure 3' d'un courant de défaut configuré pour fournir un signal de défaut proportionnel au courant de défaut en cas de défaut dans l'installation électrique comprenant au moins un tore 4' traversé par au moins deux des conducteurs 2, 2', 2", N formant un enroulement primaire et comprenant au moins un enroulement secondaire 5' apte à fournir le signal de défaut.

Ce module de détection et de commande 6' peut comprendre un circuit 16 d'excitation du tore 4' comportant un générateur de signaux alternatifs 17 produisant une porteuse périodique SPE, et, enfin, un enroulement de mesure 5' apte et destiné à générer un signal de défaut résultant de l'apparition d'un défaut différentiel au niveau du réseau, ledit enroulement de mesure 5' étant relié à des circuits 18, 19, 20 de traitement et d'évaluation du signal de défaut et d'émission d'un signal de commande SC' pour l'actionneur 7, les circuits 18 à 20 précités étant arrangés pour former une chaîne électronique opérationnelle appartenant au module de détection et de commande 6' (figures 1 et 3).

Le module de détection et de commande 6' forme un module DC.

Les deux modules de détection et de commande 6 et 6' sont reliés, à leur sortie, par l'intermédiaire d'un circuit OU 14 à l'unique actionneur 7 du dispositif 1.

Un dispositif 1 comprenant deux modules 6 et 6' en parallèle et en concurrence est par exemple connu du document WO 2017/093670 de la demanderesse.

L'invention concerne également un appareil électrique de protection.

Conformément à l'invention l'appareil électrique de protection est caractérisé en ce qu'il comprend le dispositif de protection différentielle selon l'invention, tel que décrit précédemment.

Préférentiellement, l'appareil électrique de protection peut consister en un interrupteur différentiel ou un disjoncteur différentiel de type B ou B+ de préférence sélectif.

## Revendications

1. Dispositif (1) de protection différentielle pour la détection de courants de fuite ou de défaut dans une installation électrique, laquelle est apte et destinée à être alimentée, soit par au moins deux conducteurs (2, 2', 2", N) d'un réseau, soit par au moins un conducteur de phase (2, 2', 2") du réseau et par un conducteur de neutre (N) du réseau, le dispositif (1) comprenant :
- un module de mesure (3) d'un courant de défaut configuré pour fournir un signal de défaut proportionnel au courant de défaut en cas de défaut dans l'installation électrique comprenant au moins un tore (4) traversé par au moins deux des conducteurs (2, 2', 2", N) formant un enroulement primaire et comprenant au moins un enroulement secondaire (5, 5") apte à fournir le signal de défaut,
- un module de détection et de commande (6) configuré pour traiter une composante alternative du signal de défaut et dont les fréquences sont comprises entre quelques dizaines de Hertz à quelques dizaines de kiloHertz, et pour commander un actionneur (7) que comprend le dispositif (1) si le signal de défaut franchit un seuil de déclenchement prédéterminé,
le module de détection et de commande (6) étant autonome en termes d'alimentation électrique et étant indépendant de la tension du réseau et étant relié au moins audit au moins un enroulement secondaire (5, 5") pour être alimenté par le courant de défaut,
dispositif (1) **caractérisé en ce que** :
le module de détection et de commande (6) comprend une unité de traitement (8) dudit signal de défaut, configurée pour fournir en sortie de l'unité de traitement (8) un signal traité dont la tension à 50 Hertz est supérieure à la tension à 1 kiloHertz pour une même valeur de l'intensité de courant de défaut
et **en ce que** l'unité de traitement (8) comprend un circuit électronique comprenant une première branche (8') comprenant un condensateur (Cz), dont au moins l'impédance à 50 Hertz est supérieure à l'impédance à 1000 Hertz, en série avec au moins un composant dont la résistance varie en fonction de la tension, préférentiellement une diode (D1).

2. Dispositif selon la revendication 1, **caractérisé en ce qu'**il comprend un unique enroulement secondaire (5) et **en ce que** le module de détection et de commande (6) est relié aux bornes (5a, 5b) de l'unique enroulement secondaire (5).

3. Dispositif selon la revendication 1, **caractérisé en ce qu'**il comprend un premier enroulement secondaire (5) et un deuxième enroulement secondaire (5"), et **en ce que** le module de détection et de commande est relié aux bornes du premier enroulement secondaire et à au moins une borne du deuxième enroulement secondaire.

4. Dispositif selon l'une quelconque des revendications 1 à 3, **caractérisé en ce que** le circuit électronique de l'unité de traitement (8) comprend, en outre, une deuxième branche (8") comprenant une première résistance (Rs1) reliée à un premier noeud (N1) de la première branche (8') en amont de ce dernier.

5. Dispositif selon la revendication 4, **caractérisé en ce que** le circuit électronique de l'unité de traitement (8) comprend, en outre, une troisième branche (8‴) comprenant une deuxième résistance (Rs2) reliée au premier noeud (N1) en aval de ce dernier.

6. Dispositif selon l'une quelconque des revendications 1 à 5, **caractérisé en ce que** le module de détection et de commande (6) comprend, en outre, un circuit de filtrage (9) pour filtrer une bande passante de fréquences du signal de défaut, relié aux bornes (5a, 5b, 5c) dudit au moins un enroulement secondaire (5, 5") entre le module de mesure (3) et l'unité de traitement (8).

7. Dispositif selon la revendication 6 dans sa combinaison avec la revendication 2, **caractérisé en ce que** le circuit de filtrage (9) est relié aux bornes (5a, 5b) de l'unique enroulement secondaire (5).

8. Dispositif selon la revendication 6 dans sa combinaison avec la revendication 3, **caractérisé en ce que** le circuit de filtrage (9) est relié aux bornes (5a, 5b) dudit du premier enroulement secondaire (5).

9. Dispositif selon l'une quelconque des revendications 1 à 8, **caractérisé en ce que** le module de détection et de commande (6) comprend, en outre, un élément de protection (10) contre un courant de défaut fort, en amont de l'unité de traitement (8).

10. Dispositif selon l'une quelconque des revendications 1 à 9, **caractérisé en ce que** le module de détection et de commande (6) comprend, en outre, un circuit multiplieur de tension (11) relié électriquement en aval de l'unité de traitement (8).

11. Dispositif selon la revendication 10, **caractérisé en ce que** le module de détection et de commande (6) comprend, en outre, des moyens de stockage de l'énergie (12) pour commander ledit actionneur (7), relié électriquement en aval du circuit multiplieur de tension (11).

12. Dispositif selon l'une quelconque des revendication 1 à 11, **caractérisé en ce qu'**il comprend, en outre, un module de détection et de commande (6') qui est fonctionnellement actif ou opérationnel pour des fréquences du signal de défaut de 0 Hertz à quelques dizaines de Hertz, ce module de détection et de commande (6') étant alimenté par le réseau, ce module de détection et de commande (6') comprenant un module de mesure (3') d'un courant de défaut configuré pour fournir un signal de défaut proportionnel au courant de défaut en cas de défaut dans l'installation électrique comprenant au moins un tore (4') traversé par au moins deux des conducteurs (2, 2', 2", N) formant un enroulement primaire et comprenant au moins un enroulement secondaire (5') apte à fournir le signal de défaut.

13. Appareil électrique de protection, **caractérisé en ce qu'**il comprend le dispositif de protection différentielle selon l'une quelconque des revendications 1 à 12.

## Patentansprüche

1. Differentialschutzvorrichtung (1) zur Erfassung von Leck- oder Fehlerströmen in einer elektrischen Anlage, die geeignet und dazu bestimmt ist, entweder durch mindestens zwei Leiter (2, 2', 2", N) eines Netzes oder durch mindestens einen Phasenleiter (2, 2', 2") des Netzes und durch einen Neutralleiter (N) des Netzes versorgt zu werden, wobei die Vorrichtung (1) enthält:
- ein Messmodul (3) eines Fehlerstroms, das konfiguriert ist, im Fall eines Fehlers in der elektrischen Anlage ein Fehlersignal proportional zum Fehlerstrom zu liefern, das mindestens einen Ringkern (4) enthält, der von mindestens zwei der Leiter (2, 2', 2", N) durchquert wird, die eine Primärwicklung bilden, und mindestens eine Sekundärwicklung (5, 5") enthält, die geeignet ist, das Fehlersignal zu liefern,
- ein Erfassungs- und Steuermodul (6), das konfiguriert ist, um eine Wechselstromkomponente des Fehlersignals zu verarbeiten und dessen Frequenzen zwischen einigen zehn Hertz und einigen zehn Kilohertz liegen, und um ein Stellglied (7) zu steuern, das die Vorrichtung (1) enthält, wenn das Fehlersignal eine vorbestimmte Auslöseschwelle überschreitet,
wobei das Erfassungs- und Steuermodul (6) bezüglich der Stromversorgung autonom und von der Spannung des Netzes unabhängig ist und mit der mindestens einen Sekundärwicklung (5, 5") verbunden ist, um vom Fehlerstrom versorgt zu werden,
wobei die Vorrichtung (1) **dadurch gekennzeichnet ist, dass**:
das Erfassungs- und Steuermodul (6) eine Verarbeitungseinheit (8) des Fehlersignals enthält, die konfiguriert ist, um am Ausgang der Verarbeitungseinheit (8) ein verarbeitetes Signal zu liefern, dessen Spannung bei 50 Hertz höher ist als die Spannung bei 1 Kilohertz für einen gleichen Wert der Stärke des Fehlerstroms,
und dass die Verarbeitungseinheit (8) eine Elektronikschaltung enthält, die einen ersten Zweig (8') enthält, der einen Kondensator (Cz) enthält, von dem mindestens die Impedanz bei 50 Hertz höher ist als die Impedanz bei 1000 Hertz, in Reihe mit mindestens einem Bauteil, dessen Widerstand abhängig von der Spannung variiert, vorzugsweise eine Diode (D1).

2. Vorrichtung nach Anspruch 1, **dadurch gekennzeichnet, dass** sie eine einzige Sekundärwicklung (5) enthält, und dass das Erfassungs- und Steuermodul (6) mit den Klemmen (5a, 5b) der einzigen Sekundärwicklung (5) verbunden ist.

3. Vorrichtung nach Anspruch 1, **dadurch gekennzeichnet, dass** sie eine erste Sekundärwicklung (5) und eine zweite Sekundärwicklung (5") enthält, und dass das Erfassungs- und Steuermodul mit den Klemmen der ersten Sekundärwicklung und mit mindestens einer Klemme der zweiten Sekundärwicklung verbunden ist.

4. Vorrichtung nach einem der Ansprüche 1 bis 3, **dadurch gekennzeichnet, dass** die Elektronikschaltung der Verarbeitungseinheit (8) außerdem einen zweiten Zweig (8") enthält, der einen ersten Widerstand (Rs1) enthält, der mit einem ersten Knoten (N1) des ersten Zweigs (8') stromaufwärts vor diesem letzteren verbunden ist.

5. Vorrichtung nach Anspruch 4, **dadurch gekennzeichnet, dass** die Elektronikschaltung der Verarbeitungseinheit (8) außerdem einen dritten Zweig (8‴) enthält, der einen zweiten Widerstand (Rs2) enthält, der mit dem ersten Knoten (N1) stromabwärts hinter diesem letzteren verbunden ist.

6. Vorrichtung nach einem der Ansprüche 1 bis 5, **dadurch gekennzeichnet, dass** das Erfassungs- und Steuermodul (6) außerdem eine Filterschaltung (9) zum Filtern einer Bandbreite von Frequenzen des Fehlersignals enthält, die mit den Klemmen (5a, 5b, 5c) der mindestens einen Sekundärwicklung (5, 5") zwischen dem Messmodul (3) und der Verarbeitungseinheit (8) verbunden ist.

7. Vorrichtung nach Anspruch 6 in Kombination mit Anspruch 2, **dadurch gekennzeichnet, dass** die Filterschaltung (9) mit den Klemmen (5a, 5b) der einzigen Sekundärwicklung (5) verbunden ist.

8. Vorrichtung nach Anspruch 6 in Kombination mit Anspruch 3, **dadurch gekennzeichnet, dass** die Filterschaltung (9) mit den Klemmen (5a, 5b) der ersten Sekundärwicklung (5) verbunden ist.

9. Vorrichtung nach einem der Ansprüche 1 bis 8, **dadurch gekennzeichnet, dass** das Erfassungs- und Steuermodul (6) außerdem ein Schutzelement (10) gegen einen starken Fehlerstrom stromaufwärts vor der Verarbeitungseinheit (8) enthält.

10. Vorrichtung nach einem der Ansprüche 1 bis 9, **dadurch gekennzeichnet, dass** das Erfassungs- und Steuermodul (6) außerdem eine Spannungsmultipliziererschaltung (11) enthält, die elektrisch stromabwärts hinter der Verarbeitungseinheit (8) verbunden ist.

11. Vorrichtung nach Anspruch 10, **dadurch gekennzeichnet, dass** das Erfassungs- und Steuermodul (6) außerdem Einrichtungen zum Speichern der Energie (12) zum Steuern des Stellglieds (7) enthält, die elektrisch stromabwärts hinter der Spannungsmultipliziererschaltung (11) verbunden sind.

12. Vorrichtung nach einem der Ansprüche 1 bis 11, **dadurch gekennzeichnet, dass** sie außerdem ein Erfassungs- und Steuermodul (6') enthält, das funktionell aktiv oder betriebsbereit ist für Frequenzen des Fehlersignals von 0 Hertz bis zu einigen zehn Hertz, wobei dieses Erfassungs- und Steuermodul (6') vom Netz versorgt wird, wobei dieses Erfassungs- und Steuermodul (6') ein Messmodul (3') eines Fehlerstroms enthält, das konfiguriert ist, um im Fall eines Fehlers in der elektrischen Anlage ein Fehlersignal proportional zum Fehlerstrom zu liefern, das mindestens einen Ringkern (4') enthält, der von mindestens zwei der Leiter (2, 2', 2", N) durchquert wird, die eine Primärwicklung bilden, und mindestens eine Sekundärwicklung (5') enthält, die geeignet ist, das Fehlersignal zu liefern.

13. Elektrisches Schutzgerät, **dadurch gekennzeichnet, dass** es die Differentialschutzvorrichtung nach einem der Ansprüche 1 bis 12 enthält.

## Claims

1. Differential protection device (1) for detecting leakage or fault currents in an electrical installation, which is able and intended to be powered, either by at least two conductors (2, 2', 2", N) of a network, or by at least one phase conductor (2, 2', 2") of the network and by a neutral conductor (N) of the network, the device (1) comprising:
- a module (3) for measuring a fault current configured to supply a fault signal proportional to the fault current in the case of a fault in the electrical installation comprising at least one toroid (4) passed through by at least two of the conductors (2, 2', 2", N) forming a primary winding and comprising at least one secondary winding (5, 5") capable of supplying the fault signal,
- a detection and control module (6) configured to process an alternating component of the fault signal, the frequencies of which lie between a few tens of Hertz and a few tens of kiloHertz, and to control an actuator (7) that the device (1) comprises if the fault signal crosses a predetermined trigger threshold,
the detection and control module (6) being autonomous in terms of electrical power supply and being independent of the voltage of the network and being linked at least to said at least one secondary winding (5, 5") to be powered by the fault current,
which device (1) is **characterized in that**:
the detection and control module (6) comprises a processing unit (8) for processing said fault signal, configured to supply, as output of the processing unit (8), a processed signal, the voltage at 50 Hertz of which is greater than the voltage at 1 kiloHertz for one and the same fault current intensity value
and **in that** the processing unit (8) comprises an electronic circuit comprising a first branch (8') comprising a capacitor (Cz) of which at least the impedance at 50 Hertz is greater than the impedance at 1000 Hertz, in series with at least one component the resistance of which varies as a function of the voltage, preferentially a diode (D1).

2. Device according to Claim 1, **characterized in that** it comprises a single secondary winding (5) and **in that** the detection and control module (6) is linked to the terminals (5a, 5b) of the single secondary winding (5).

3. Device according to Claim 1, **characterized in that** it comprises a first secondary winding (5) and a second secondary winding (5"), and **in that** the detection and control module is linked to the terminals of the first secondary winding and to at least one terminal of the second secondary winding.

4. Device according to any one of Claims 1 to 3, **characterized in that** the electronic circuit of the processing unit (8) further comprises a second branch (8") comprising a first resistor (Rs1) linked to a first node (N1) of the first branch (8') upstream thereof.

5. Device according to Claim 4, **characterized in that** the electronic circuit of the processing unit (8) further comprises a third branch (8"') comprising a second resistor (Rs2) linked to the first node (N1) downstream thereof.

6. Device according to any one of Claims 1 to 5, **characterized in that** the detection and control module (6) further comprises a filtering circuit (9) for filtering a passband of frequencies of the fault signal, linked to the terminals (5a, 5b, 5c) of said at least one secondary winding (5, 5") between the measurement module (3) and the processing unit (8).

7. Device according to Claim 6 in its combination with Claim 2, **characterized in that** the filtering circuit (9) is linked to the terminals (5a, 5b) of the single secondary winding (5).

8. Device according to Claim 6 in its combination with Claim 3, **characterized in that** the filtering circuit (9) is linked to the terminals (5a, 5b) of the first secondary winding (5).

9. Device according to any one of Claims 1 to 8, **characterized in that** the detection and control module (6) further comprises a protection element (10) for protection against a strong fault current, upstream of the processing unit (8).

10. Device according to any one of Claims 1 to 9, **characterized in that** the detection and control module (6) further comprises a voltage multiplier circuit (11) linked electrically downstream of the processing unit (8) .

11. Device according to Claim 10, **characterized in that** the detection and control module (6) further comprises means for storing energy (12) to control said actuator (7), linked electrically downstream of the voltage multiplier circuit (11).

12. Device according to any one of Claims 1 to 11, **characterized in that** it further comprises a detection and control module (6') which is functionally active or operational for frequencies of the fault signal from 0 Hertz to a few tens of Hertz, this detection and control module (6') being powered by the network, this detection and control module (6') comprising a module (3') for measuring a fault current configured to supply a fault signal proportional to the fault current in the case of a fault in the electrical installation comprising at least one toroid (4') passed through by at least two of the conductors (2, 2', 2", N) forming a primary winding and comprising at least one secondary winding (5') capable of supplying the fault signal.

13. Electrical protection unit, **characterized in that** it comprises the differential protection device according to any one of Claims 1 to 12.
